# EUROPÄISCHE PATENTANMELDUNG

(11) **EP 2 521 430 A1**
(43) Veröffentlichungstag der Anmeldung: **07.11.2012**
(21) Anmeldenummer: 11165116.2
(22) Anmeldetag: 06.05.2011
(51) Int. Cl.: H05K 7/20, H05K 3/00

(54) **Verfahren zur Befestigung einer Leiterplatte auf einem Körper sowie elektromotorisch angetriebene Pumpe**

(71) Anmelder: Pierburg Pump Technology GmbH, 41460 Neuss (DE)
(72) Erfinder: Geinitz, Rene, 04683, Naunhof (DE); Friede, Hagen, 04736, Waldheim (DE); Stephan, Schreckenberg, 50259, Pulheim-Stommeln (DE)
(74) Vertreter: ter Smitten, Hans

(57) **Zusammenfassung**

Es sind Verfahren zur Befestigung einer Leiterplatte (12) auf einem Körper (2), wobei zunächst ein Kleber auf dem Körper (2) oder auf einer Unterseite (20) der Leiterplatte (12) aufgetragen wird, anschließend die Leiterplatte (12) mit ihrer Unterseite (20) auf den Körper (2) aufgesetzt wird und darauf folgend die Leiterplatte (12) mit einer Kraft in Richtung zum Körper (2) belastet wird, bekannt. Genutzt wird dies häufig für elektromotorisch angetriebene Pumpen, insbesondere Kühlmittelpumpen für einen Verbrennungsmotor, mit einer Elektronik, welche eine Leiterplatte (12) aufweist, die auf einem Gehäuse oder einer im Gehäuse angeordneten Kühlplatte (4) mittels eines Klebers befestigt ist.

Bei der Herstellung dieser Verbindungen entstehen häufig durch die mechanisch aufgebrachte Kraft Brüche der Leiterplatte (12) oder eine nicht ausreichende Wärmeableitung.

Es wird daher ein Verfahren vorgeschlagen, bei dem die Kraft durch eine auf die Leiterplatte (12) wirkende Umgebungsluftdruckdifferenz zwischen einer zur Unterseite (20) gegenüberliegenden Oberseite (14) der Leiterplatte (12) und der Unterseite (20) der Leiterplatte (12) erzeugt wird.

## Beschreibung

Die Erfindung betrifft ein Verfahren zur Befestigung einer Leiterplatte auf einem Körper, wobei zunächst ein Kleber auf dem Körper oder auf einer Unterseite der Leiterplatte aufgetragen wird, anschließend die Leiterplatte mit ihrer Unterseite auf den Körper aufgesetzt wird und darauf folgend die Leiterplatte mit einer Kraft in Richtung zum Körper belastet wird, sowie eine elektromotorisch angetriebene Pumpe, insbesondere Kühlmittelpumpe für einen Verbrennungsmotor, mit einer Elektronik, welche eine Leiterplatte aufweist, die auf einem Gehäuse oder einer im Gehäuse angeordneten Kühlplatte mittels eines Klebers befestigt ist.

Zur Steuerung von elektromotorisch angetriebenen Pumpen wird üblicherweise eine Platine mit Steuerungs- und Leistungsbausteinen in einem Gehäuse der Pumpe oder des Elektromotors oder in einem separaten Elektronikgehäuse befestigt. Diese Befestigung kann kraftschlüssig, stoffschlüssig oder formschlüssig erfolgen. Häufig ist es erforderlich, diese Platinen zu kühlen. Dies ist insbesondere der Fall, wenn eine Verwendung in ohnehin wärmeren Bereichen stattfindet. Daher wurde vorgeschlagen, die häufig als Keramiksubstrate ausgeführten Platinen wärmeleitend an einem Kühlkörper anzuordnen, der entweder Kühlrippen aufweist oder aktiv durch Kühlwasser gekühlt wird. Bei der Verwendung von Elektronikeinheiten in elektrischen Kühlmittelpumpen erfolgt daher häufig die Anbindung an einem Gehäuseteil, welches an seiner gegenüberliegenden Seite von Kühlmittel umströmt ist und somit als Kühlkörper dient. Damit eine ausreichende Wärmeabfuhr vom Substrat zum Gehäuse stattfindet, muss die Anbindung möglichst flächig und mit möglichst geringem Abstand zum anzubindenden Gehäuse ausgeführt werden.

Entsprechend wird in der DE 100 51 945 C1 eine dichte Aufnahmekammer für ein Kraftfahrzeugelektronikbauteil offenbart, bei dem ein Keramiksubstrat, welches die Verdrahtungsplattform für Elektronikbauelemente bildet, mittels eines Wärmeleitklebers auf einer Trägerplatte befestigt ist. Des Weiteren ist es aus dieser Schrift bekannt, eine dichte Verklebung zwischen einer Leiterplatte und einer Trägerplatte herzustellen, indem die Leiterplatte, welche flexibel als Folie ausgeführt ist, mittels hohem Druck auf die Trägerplatte unter Zwischenlage eines Klebers aufgedrückt wird.

Jedoch wird eine solche dichte Verklebung bei Keramiksubstraten nicht durchgeführt, da der aufzubringende Druck durch die bekannten Stempel und Walzen mechanisch nicht vollflächig erzeugt werden kann, wodurch diese Substrate bei der Aufbringung des Druckes brechen beziehungsweise reißen. Wird dieser Druck nicht aufgebracht, ist jedoch die Klebeschicht in der Regel zu dick oder weist isolierende Luftkammern auf, wodurch bei Anwendungen mit hoher thermischer Belastung häufig keine ausreichende Wärmeabfuhr mehr sichergestellt werden kann.

Es stellt sich daher die Aufgabe, ein Verfahren zur Befestigung einer Leiterplatte auf einen Körper sowie eine Pumpe mit einer auf einem Körper befestigten Leiterplatte bereitzustellen, wobei eine ausreichende Wärmeableitung sichergestellt wird und gleichzeitig eine Beschädigung der Leiterplatte zuverlässig vermieden wird.

Diese Aufgabe wird durch ein Verfahren zur Befestigung einer Leiterplatte auf einem Körper mit den Merkmalen des Anspruchs 1 sowie eine elektromotorisch angetriebene Pumpe mit den Merkmalen des Anspruchs 11 gelöst.

Dadurch, dass die Kraft durch eine auf die Leiterplatte wirkende Umgebungsluftdruckdifferenz zwischen einer zur Unterseite gegenüberliegenden Oberseite der Leiterplatte und der Unterseite der Leiterplatte erzeugt wird, muss kein mechanischer Druck aufgebracht werden. Es entsteht eine vollflächige Anpresskraft, die zu einer gleichmäßigen Verklebung führt, deren Höhe abhängig von der Größe der Bestandteile in der Paste ist und beispielsweise etwa 100µm beträgt, so dass der Wärmetransport zum Kühlkörper oder Gehäuse gesteigert wird. Ein Brechen der Leiterplatte wird durch diese gleichmäßig wirkende Anpresskraft verhindert. Somit kann das Thermomanagement einer thermisch belasteten Pumpe, insbesondere einer Kühlmittelpumpe für den Kühlkreislauf einer Verbrennungskraftmaschine stabil gehalten werden.

Vorzugsweise wirkt zwischen dem Körper und der Leiterplatte ein Druck, der geringer ist als ein Atmosphärendruck, während auf der dem Kleber abgewandten Seite der Leiterplatte ein Atmosphärendruck wirkt. Diese Druckdifferenz ist besonders einfach und somit kostengünstig herstellbar.

In einer bevorzugten Ausführung wird der Kleber in Form einer umlaufend geschlossenen Kleberaupe aufgebracht, wobei nach dem Aufsetzen der Leiterplatte zunächst durch Erzeugen eines Vakuums in der Umgebung der Baugruppe, die aus dem Körper und der Leiterplatte besteht, ein Vakuumraum durch den Körper, die Leiterplatte und die Kleberaupe abgegrenzt wird und anschließend die Umgebung der Baugruppe einem Atmosphärendruck ausgesetzt wird, wodurch die Druckdifferenz zwischen dem abgegrenzten Vakuumraum und der Oberseite der Leiterplatte hergestellt wird. Durch das Evakuieren wird die vorhandene Luft komplett aus dem Raum unter der Leiterplatte gezogen, wodurch diese sich fester auf die Kleberaupe setzt. Dies hat im Folgenden eine Abdichtung zwischen Leiterplatte und Körper durch die Kleberaupe zur Folge. Wird die Baugruppe im Folgenden wieder dem Atmosphärendruck ausgesetzt, verbleibt das Vakuum im abgedichteten Raum, wodurch die Druckdifferenz, die erzeugt wird, zu einer auf die Leiterplatte wirkenden Anpresskraft führt. So können extrem dünne Klebeschichten bei einer gleichmäßigen Belastung der Leiterplatte erzeugt werden.

In einer hierzu weiterführenden Ausgestaltung wird das Vakuum in einer Vakuumkammer erzeugt, in welcher der Körper mit der Leiterplatte eingesetzt wird. Eine solche Kammer kann sehr klein sein, wodurch sehr kurze Taktzeiten bei der Fertigung erreicht werden können.

Vorzugsweise wird die Leiterplatte als Keramiksubstrat hergestellt. Diese weisen besonders gute Wärmeleiteigenschaften auf, so dass sie auch in thermisch belasteten Bereichen eingesetzt werden können. Auch kann ein mehrlagiger Schaltungsaufbau verwirklicht werden.

Vorzugsweise wird als Körper ein Gehäuse oder eine Kühlplatte verwendet. Bei der Verwendung des Gehäuses als Körper sind keine zusätzlichen Teile zu montieren, so dass der Herstellungsaufwand sinkt. Bei thermischer Belastung sollten Kühlplatten verwendet werden, mit denen die Wärmeableitung zusätzlich verbessert wird.

In einer Weiterbildung der Erfindung wird zur Erzeugung der Kleberaupe ein Kleber verwendet, der thermisch leitend und elektrisch isolierend wirkt. Derartige Wärmeleitkleber verbessern den Wärmetransport zwischen dem Substrat und einem Kühlkörper noch einmal erheblich, wodurch beispielsweise die Verwendung derartiger Elektronikeinheiten mit Leistungshalbleitern in Kühlmittelpumpen von Kraftfahrzeugen ermöglicht wird.

Dabei weist der Kleber eine Viskosität von 100.000 mPas bis 300.000mPas auf, wodurch ein zielgenaues tropffreies Auftragen möglich wird.

Wenn dem Kleber homogen verteilt Festkörper beigemischt werden, ist es möglich, eine definierte Kleberschichtdicke zu erzeugen, die im Wesentlichen dem Durchmesser des beigemischten Feststoffes entspricht.

In einer besonders bevorzugten Ausführung wird die Kleberaupe sich spiralförmig erweiternd aufgetragen, wobei die radial außenliegende Windung der Kleberaupe allseitig geschlossen ausgebildet wird. Bei der Evakuierung wird durch diese Anordnung erreicht, dass Luft entlang der Bahn zwischen den Kleberaupen von innen nach außen entweichen kann. Lediglich ganz außen wirkt die geschlossene Raupe als Dichtung. Auf diese Weise wird verhindert, dass Luft im äußeren Bereich entweicht und zu einer Dichtwirkung am Rand führt, bevor andere Bereiche vollständig evakuiert sind.

Ein derartiges Verfahren sorgt für eine langlebige Verbindung zwischen dem Körper und der Leiterplatte mit sehr guten Wärmeleiteigenschaften bei Vermeidung von Beschädigungen der Leiterplatte. Das Verfahren ist kostengünstig durchzuführen. Eine erfindungsgemäße Pumpe kann auch beim Einsatz im Kühlmittelstrang eines Verbrennungsmotors mit der Leistungssteuereinheit an der Pumpe beziehungsweise am antreibenden Elektromotor ausgerüstet werden, ohne dass hieraus eine thermische Überlastung folgen würde.

Das Verfahren wird im Folgenden anhand der Figuren beschrieben.
Figur 1 zeigt eine perspektivische Darstellung eines Körpers und einer Leiterplatte vor der Befestigung aneinander.
Figur 2 zeigt eine perspektivische Darstellung des Körpers mit der Leiterplatte in einem folgenden Verfahrensschritt.

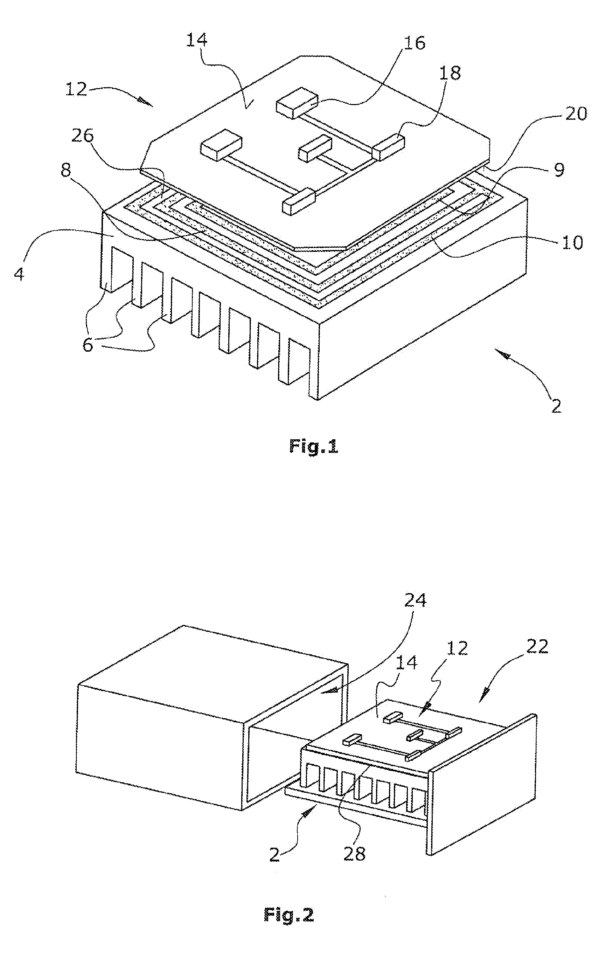

In Figur 1 ist ein Körper 2 dargestellt, der aus einem gut leitenden Metall hergestellt wird und als Kühlplatte 4 ausgestaltet ist, von der aus sich Rippen 6 zur Verbesserung der Kühlwirkung erstrecken. An der zu den Rippen 6 gegenüber liegenden Seite ist auf der Kühlplatte 4 eine Kleberaupe 8 ausgebildet, welche als eckige Spirale 9 ausgebildet ist, deren äußerste Windung 10 geschlossen ausgebildet ist.

Die Kleberaupe besteht aus einem Wärmeleitkleber, der elektrisch isolierend und thermisch leitend wirkt. Er weist eine Viskosität von etwa 200.000 mPas auf, so dass es sich um einen pastösen Kleber handelt, der gut zu dosieren ist und nicht zum Tropfen neigt.

In der Figur 1 ist über dem Körper 2 eine Leiterplatte 12 angeordnet, auf deren Oberseite 14 Leistungshalbleiter 16 und andere elektronische Bauteile 18 angeordnet sind, welche über Leitungen miteinander verbunden sind. Die Leiterplatte 12 ist als Keramiksubstrat ausgebildet, welches mit seiner Unterseite 20, welche gegenüberliegend zur Oberseite 14 angeordnet ist, auf die Kühlplatte 4 beziehungsweise die Kleberaupe 8 aufgesetzt wird. Mit dem Aufsetzen der Leiterplatte 12 auf den Körper 2 wird eine Baugruppe 22 gebildet, welche in eine Vakuumkammer 24, die schematisch in Figur 2 dargestellt ist, eingesetzt wird.

Zur besonders schnellen Evakuierung ist diese Vakuumkammer 24 nur geringfügig größer ausgebildet als die Baugruppe 22. Wird nun die Vakuumkammer 24 geschlossen und die in der Vakuumkammer 24 befindliche Luft evakuiert, wird auch die Luft zwischen den einzelnen Windungen der eckigen Spirale 9 herausgezogen bis die äußere Windung 10 vollflächig gegen die Kühlplatte 4 und die Unterseite 20 der Leiterplatte 12 anliegt. In diesem Moment dient die äußere Windung 10 der Kleberaupe 8 als Dichtung, so dass ein Vakuumraum 26 zwischen Leiterplatte 12, Kühlplatte 4 und der äußeren Windung 10 der Spirale 9 gebildet wird. Durch die spiralförmige Ausbildung der Kleberaupe 8 wird dabei sichergestellt, dass innerhalb des Vakuumraums 26 überall der gleiche Druck herrscht.

Wird im Folgenden die Vakuumkammer 24 wieder belüftet, entsteht eine Druckdifferenz über die Leiterplatte 12, da im Vakuumraum 26 der geringere Druck der Vakuumkammer 24 vorhanden bleibt, welcher auf die Unterseite 20 der Leiterplatte 12 wirkt, während auf die Oberseite 14 nun der Atmosphärendruck wirkt. Dies hat zur Folge, dass auf die gesamte Oberfläche der Leiterplatte 12 eine gleichmäßige Kraft wirkt, die dazu führt, dass die Leiterplatte 12 auf die Kühlplatte 4 gedrückt wird.

Die entstehende Kleberschicht 28 ist lediglich etwa 100µm dick und sehr gleichmäßig. So wird eine optimierte Wärmeableitung von den Wärme erzeugenden Leistungshalbleitern 16 in Richtung zur Kühlplatte 4 und somit zu den Rippen 6 sichergestellt. Durch die Beimischung von Feststoffen in den pastösen Kleber kann die Dicke der entstehenden Schicht 28 entsprechend des größten Durchmessers der beigemischten Feststoffe eingestellt werden.

Die so hergestellte Baugruppe 22 kann in ein Elektronikgehäuse einer Kühlmittelpumpe für ein Kraftfahrzeug eingesetzt und befestigt werden. Auch kann die Leiterplatte 12 an einem anderen Körper 2, wie beispielswiese an der Rückseite einer das Spiralgehäuse eines Pumpenkopfes begrenzenden Platte einer Kühlmittelpumpe angeordnet werden.

Dieses Verfahren eignet sich somit zur Ausbildung von extrem dünnen und gut wärmeleitenden Kleberschichten, so dass die Elektronik im Vergleich zu bislang bekannten Ausführungen höheren thermischen Belastungen ausgesetzt werden kann, ohne dass ein Ausfall zu befürchten ist. Durch die gleichmäßige Kraftaufbringung werden Schäden an nicht stabilen Substraten bei der Verklebung zuverlässig vermieden,

Es sollte deutlich sein, dass der Schutzbereich der Anmeldung nicht auf das beschriebene Ausführungsbeispiel beschränkt ist. Die Stoffe und Formen der verwendeten Bauteile wie Leiterplatte und Körper können je nach Verwendung stark vom Ausführungsbeispiel abweichen. Entsprechend muss die Leiterplatte nicht als Keramiksubstrat ausgeführt werden. Eine Klebung in dieser Form eignet sich für jede Anwendung, bei der aus dem Bereich der Elektronik Wärme abgeführt werden muss.

## Patentansprüche

1. Verfahren zur Befestigung einer Leiterplatte (12) auf einem Körper (2), wobei zunächst ein Kleber auf dem Körper (2) oder auf einer Unterseite (20) der Leiterplatte (12) aufgetragen wird, anschließend die Leiterplatte (12) mit ihrer Unterseite (20) auf den Körper (2) aufgesetzt wird und darauf folgend die Leiterplatte (12) mit einer Kraft in Richtung zum Körper (2) belastet wird,
**dadurch gekennzeichnet, dass**
die Kraft durch eine auf die Leiterplatte (12) wirkende Umgebungsluftdruckdifferenz zwischen einer zur Unterseite (20) gegenüberliegenden Oberseite (14) der Leiterplatte (12) und der Unterseite (20) der Leiterplatte (12) erzeugt wird.

2. Verfahren zur Befestigung einer Leiterplatte auf einem Körper nach Anspruch 1,
**dadurch gekennzeichnet, dass**
zwischen dem Körper (2) und der Leiterplatte (12) ein Druck wirkt, der geringer ist als ein Atmosphärendruck und auf der Oberseite (14) der Leiterplatte (12) der Atmosphärendruck.

3. Verfahren zur Befestigung einer Leiterplatte auf einem Körper nach Anspruch 2,
**dadurch gekennzeichnet, dass**
der Kleber in Form einer umlaufend geschlossenen Kleberaupe (8) aufgebracht wird, wobei nach dem Aufsetzen der Leiterplatte (12) zunächst durch Erzeugen eines Vakuums in der Umgebung einer Baugruppe (22), die aus dem Körper (2) und der Leiterplatte (12) besteht, ein Vakuumraum (26) durch den Körper (2), die Leiterplatte (12) und die Kleberaupe (8) abgegrenzt wird und anschließend die Umgebung der Baugruppe (22) einem Atmosphärendruck ausgesetzt wird, wodurch die Druckdifferenz zwischen dem abgegrenzten Vakuumraum (26) und der Oberseite (14) der Leiterplatte (12) hergestellt wird.

4. Verfahren zur Befestigung einer Leiterplatte auf einem Körper nach Anspruch 3,
**dadurch gekennzeichnet, dass**
das Vakuum in einer Vakuumkammer (24) erzeugt wird, in welche die Baugruppe (22) eingesetzt wird.

5. Verfahren zur Befestigung einer Leiterplatte auf einem Körper nach einem der vorhergehenden Ansprüche,
**dadurch gekennzeichnet, dass**
die Leiterplatte (12) als Keramiksubstrat hergestellt wird.

6. Verfahren zur Befestigung einer Leiterplatte auf einem Körper nach einem der vorhergehenden Ansprüche,
**dadurch gekennzeichnet, dass**
als Körper (2) ein Gehäuse oder eine Kühlplatte (4) verwendet wird.

7. Verfahren zur Befestigung einer Leiterplatte auf einem Körper nach einem der vorhergehenden Ansprüche,
**dadurch gekennzeichnet, dass**
zur Erzeugung der Kleberaupe (8) ein Kleber verwendet wird, der thermisch leitend und elektrisch isolierend wirkt.

8. Verfahren zur Befestigung einer Leiterplatte auf einem Körper nach Anspruch 7,
**dadurch gekennzeichnet, dass**
der Kleber eine Viskosität von 100.000 mPas bis 300.000mPas hat.

9. Verfahren zur Befestigung einer Leiterplatte auf einem Körper nach einem der vorhergehenden Ansprüche,
**dadurch gekennzeichnet, dass**
dem Kleber homogen verteilt Festkörper beigemischt werden.

10. Verfahren zur Befestigung einer Leiterplatte auf einem Körper nach einem der vorhergehenden Ansprüche,
**dadurch gekennzeichnet, dass**
die Kleberaupe (8) sich spiralförmig erweiternd aufgetragen wird, wobei die radial außenliegende Windung (10) der Kleberaupe (8) allseitig geschlossen ausgebildet wird.

11. Elektromotorisch angetriebene Pumpe, insbesondere Kühlmittelpumpe für einen Verbrennungsmotor, mit einer Elektronik, welche eine Leiterplatte (12) aufweist, die auf einem Gehäuse oder einer im Gehäuse angeordneten Kühlplatte (4) mittels eines Klebers befestigt ist,
**dadurch gekennzeichnet, dass**
die Befestigung mittels eines Verfahrens gemäß einem der vorhergehenden Ansprüche hergestellt ist.
